# FASCICULE DE BREVET EUROPEEN

(11) **EP 0 785 577 B1**
(45) Date de publication et mention de la délivrance du brevet: **16.03.2005**
(21) Numéro de dépôt: 97410008.3
(22) Date de dépôt: 17.01.1997
(51) Int. Cl.: H01L 27/02

(54) **Composant de protection d'interface de lignes telephoniques**
Telefonleitungs-Interface-Schutzbauelement
Telephone line interface protection component

(30) Priorité: 19.01.1996 FR 9600811
(43) Date de publication de la demande: 23.07.1997
(73) Titulaire: STMicroelectronics S.A., 92120 Montrouge (FR)
(72) Inventeur: Bernier, Eric, 37390 Mettray (FR)
(74) Mandataire: de Beaumont, Michel

(56) Documents cités:
- EP-A- 0 687 051

## Description

La présente invention concerne un composant de protection, plus particulièrement applicable à la protection de lignes téléphoniques.

La demande de brevet européen EP-A-0 687 051 de la demanderesse décrit un circuit de protection d'interface de lignes téléphoniques et des modes de réalisation particuliers de ce circuit sous forme de composant monolithique.

La figure 1 de la présente demande reproduit la figure 4 de cette demande de brevet antérieure et représente un élément de circuit comprenant deux thyristors tête-bêche Th1 et Th2, respectivement à gâchette de cathode et à gâchette d'anode, connectés entre une ligne AB et une borne de référence G. Les gâchettes sont reliées ensemble au point B. Une borne commune des thyristors est reliée au point A, une résistance Rd étant insérée entre les points A et B. L'autre borne commune des thyristors est reliée à la borne de référence G. Une diode Zener Z1 connectée entre les bornes B et G entraîne, quand elle entre en avalanche, le déclenchement du thyristor Th1 et une diode Zener Z2 connectée entre les bornes A et G entraîne, quand elle entre en avalanche, le déclenchement du thyristor Th2. Quand le courant entre les bornes A et B dépasse un seuil déterminé, l'un ou l'autre des thyristors Th1 et Th2 est mis en conduction par sa gâchette.

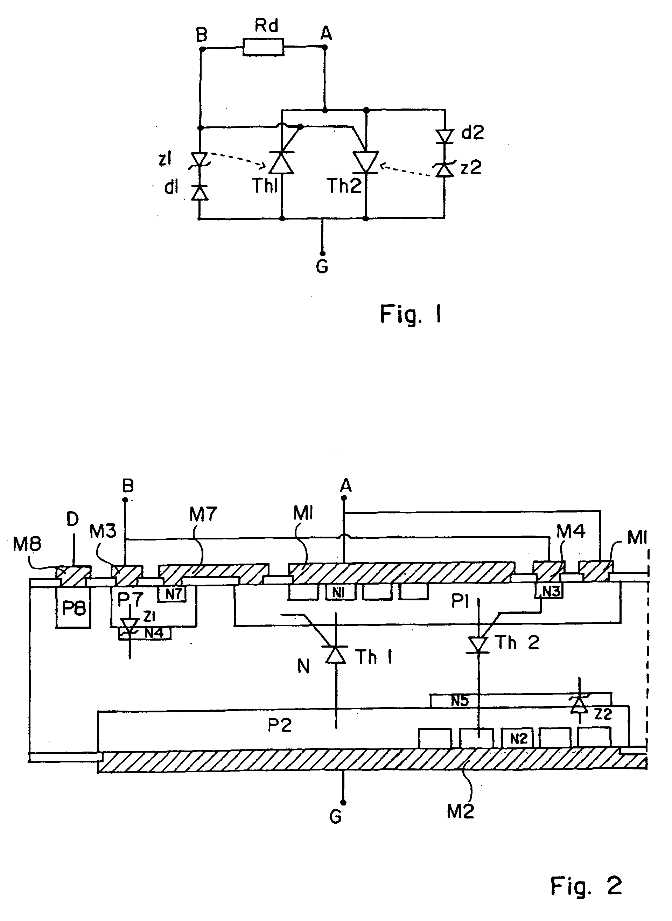

Ainsi, dans les circuits de la figure 1, selon la polarité en cause, l'un ou l'autre des thyristors Th1 et Th2 entre en conduction si le courant dans la résistance Rd dépasse un seuil déterminé ou si la tension sur la ligne AB dépasse la tension d'avalanche de la diode Z1 ou Z2.

La figure 2 de la présente demande reproduit la figure 7 de la demande de brevet susmentionnée et constitue un mode de réalisation du circuit de la figure 1. On a rajouté sur la figure 2 l'indication des emplacements des éléments Th1, Th2, Z1 et Z2 de la figure 1.

Lors de la conception et de la réalisation de l'invention faisant l'objet de la demande de brevet susmentionnée, il était apparu à l'inventeur que l'une des difficultés essentielles à résoudre résidait dans l'obtention de sensibilités équivalentes pour le déclenchement par la gâchette des thyristors Th1 et Th2 et dans l'obtention de courants de maintien appropriés. Ainsi, divers moyens ont été indiqués dans cette demande de brevet antérieure pour résoudre ce problème.

Toutefois, lors de la réalisation pratique du circuit, la demanderesse s'est aperçu que, si le déclenchement du thyristor Th1 à la suite de la mise en avalanche de la diode Zener Z1 ne posait pas de problèmes particuliers, la sensibilité de déclenchement du thyristor Th2 à la suite du passage d'un courant dans la résistance Rd devait encore être améliorée. Plus particulièrement, ce déclenchement s'est avéré trop lent (durée supérieure à 1 µs). Les efforts pour optimiser la topologie du composant (voir figures 8A et 8B de la demande de brevet européen EP-A-0 687 051) se sont avérés infructueux. Ainsi, quand une surintensité à front particulièrement raide (par exemple une onde normalisée 0,5/700 µs d'une intensité de 30 A) survient sur la ligne AB, le thyristor Th2 entre bien en conduction mais avec un certain retard et, pendant ce retard, le composant de protection va laisser passer l'intensité de crête de 30 A, ce qui peut dégrader le circuit intégré à protéger.

La présente invention vise à résoudre ce problème et à améliorer la vitesse de réaction du composant à la suite de l'apparition d'une surintensité positive sur la ligne AB.

Pour atteindre cet objet, la demanderesse a été conduite à modifier complètement la structure du composant de la figure 2 et plus particulièrement de la partie de ce composant correspondant au thyristor Th2, comme cela sera exposé ci-après.

Avec la modification selon la présente invention telle que revendiquée dans la revendication 1. On obtient une mise en conduction extrêmement rapide du thyristor Th2 à la suite d'une surintensité (moins de 1 µs après le début de la surintensité)

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 correspond à la figure 4 de la demande de brevet européen EP-A-0 687 051 ;
la figure 2 correspond à la figure 7 de la demande de brevet européen EP-A-0 687 051 ; et
la figure 3 représente un exemple d'intégration selon la présente invention de la structure de la figure 1.

Comme cela est usuel dans le domaine de la représentation des composants semiconducteurs, les vues en coupe de composants ne sont tracées à l'échelle ni horizontalement ni verticalement. Pour le choix des dimensions, l'homme de l'art se référera à ses connaissances habituelles et à ce qui est enseigné dans la demande de brevet susmentionnée.

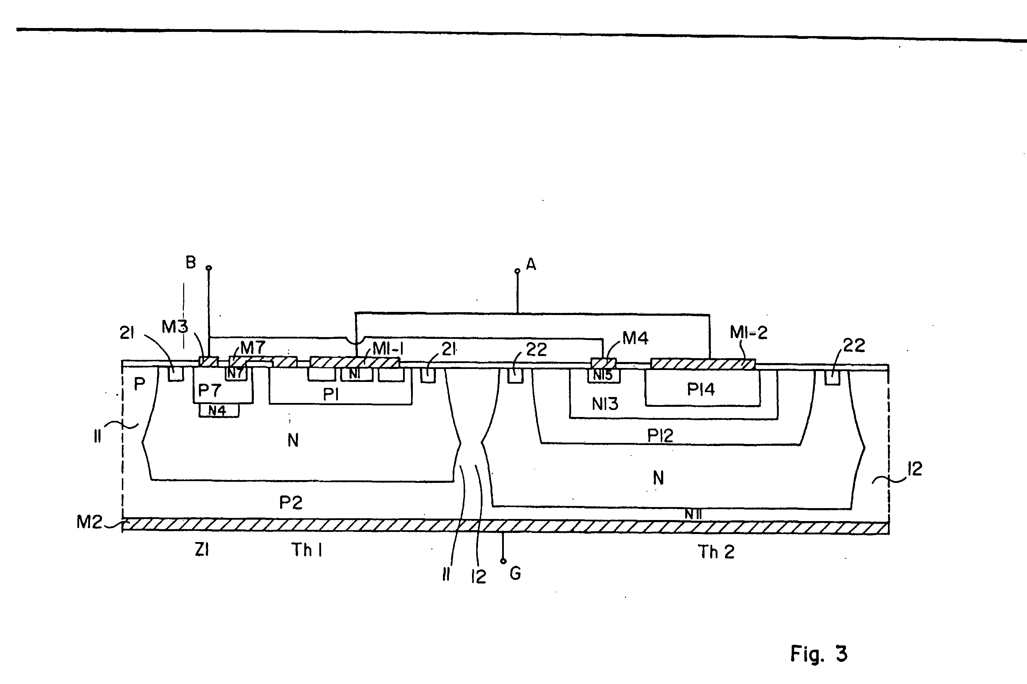

La figure 3 représente de façon schématique et simplifiée un exemple de réalisation monolithique selon la présente invention du circuit de la figure 1. Ce composant est réalisé comme celui de la figure 2 à partir d'un substrat de type N. On retrouve dans la partie gauche du composant les mêmes éléments que ceux représentés dans la partie gauche de la figure 2 désignés par les mêmes références.

Une différence par rapport au circuit de la figure 2 est que cet ensemble de couches et de régions semiconductrices est formé dans un caisson isolé par des murs de diffusions profondes 11 de type P pour isoler le thyristor Th1 et ses composants associés du thyristor Th2. Ces murs sont de façon classique formés à partir des faces supérieure et inférieure du substrat. En outre, on n'a pas représenté en figure 3 la région P8 de détection de court-circuit mais celle-ci pourra bien entendu être prévue si on le souhaite.

Ainsi, la partie gauche de la figure 3 comprend, du côté de la face inférieure du substrat, une couche P2 de type P et, du côté de la face supérieure du substrat, des régions P1 et P7 de type P dans lesquelles sont respectivement formées des régions N1 et N7 de type N. A l'interface entre la région P7 et le substrat N est formée une région N4 de type N.

La face inférieure de la plaquette est revêtue d'une métallisation M2. La région P7 est revêtue d'une métallisation M3. La région N7 et une portion de la région P1 sont revêtues d'une métallisation M7. La région N1 est revêtue d'une métallisation M1-1 qui correspond à une portion de la métallisation M1 de la figure 2.

Comme cela est décrit dans la demande de brevet européen susmentionnée, cette structure constitue une réalisation de l'ensemble du thyristor Th1 et de la diode Zener Z1 de la figure 1. Le thyristor Th1 comprend les régions N1-P1-N-P2 et est associé aux régions N7 et P7 pour constituer un thyristor à amplification de gâchette. La diode Zener Z1 est formée par la jonction entre les régions P7 et N4 spécialement conçue pour assurer cette fonction.

La partie droite de la figure 3 représente une réalisation des éléments correspondant à l'ensemble du thyristor Th2 et de la diode Zener Z2 de la figure 1. Comme on le notera ci-après, il n'y a pas de distinction entre le thyristor Th2 et la diode Z2, cette diode correspondant à l'une des jonctions du thyristor qui est en fait un thyristor à déclenchement en direct par retournement. Cette structure est éventuellement formée dans un caisson isolé par des murs de diffusion verticaux 12 de type P.

Dans cette partie droite, la face arrière est occupée par une couche N11 de type N fortement dopée formée par diffusion ou implantation-diffusion. Du côté de la face avant, sont successivement formées une diffusion profonde P12 de type P ; à l' intérieur de la région P12, une diffusion profonde N13 de type N et ; à l'intérieur de la région N13, des régions disjointes P14 de type P et N15 de type N.

Le thyristor Th2, de son anode vers sa cathode, correspond à l'ensemble des régions et couches P14-N13-P12-N-N11. La région N15 est une région de reprise de contact de gâchette d'anode. La région d'anode P14 est revêtue d'une métallisation M1-2 reliée à la métallisation M1-1. La région N15 de reprise de contact de gâchette d'anode est revêtue d'une métallisation M4 correspondant à la métallisation portant la même référence en figure 2 et reliée à la borne B.

Dans cette structure, quand le thyristor Th2 est polarisé en direct, la jonction susceptible d'entrer en avalanche est la jonction N13-P12. C'est donc cette jonction qui doit être optimisée pour présenter un seuil de déclenchement désiré, de préférence voisin de celui de la jonction P7-N4. Les régions P12 et M13 étant formées par des diffusions successives, il est possible d'optimiser les niveaux de dopage et les profils de diffusion pour que cette jonction présente les caractéristiques souhaitées.

Egalement, si l'on considère le thyristor Th2 comme constitué d'un assemblage de deux transistors PNP P14-N13-P12 et NPN N13-P12-N-N11, les gains de ces transistors pourront être optimisés pour augmenter la sensibilité du thyristor Th2, conformément à l'objet de l'invention.

La réalisation d'un tel composant ne nécessite pas d'étape supplémentaire de fabrication par rapport à celle du composant de la figure 2 (en notant que, bien que l'on n'ait pas illustré dans la vue partielle de la figure 2 de mur d'isolement, il existera en pratique des murs d'isolement dans la structure d'ensemble dont le composant de la figure 2 fait partie). Plus particulièrement, la région P12 pourra être réalisée en même temps que la partie supérieure des murs d'isolement 11 et 12, la région N13 pourra être réalisée en même temps que la région N4, la région P14 en même temps que les régions P1 et P7 et la région N15 en même temps que les régions N1, N7 et N11. Toutefois, bien que résultant des mêmes étapes de diffusion, c'est-à-dire même durée et même température de recuit, ces diffusions pourront faire suite à des implantations de doses distinctes. En particulier, le niveau de dopage de la région P12 sera nettement inférieur à celui des murs d'isolement.

A titre d'exemple de valeurs numériques, on pourra choisir pour diverses régions les valeurs de concentration superficielle Cs (en atomes/cm³) et de profondeur de jonction xj (en µm) suivantes.

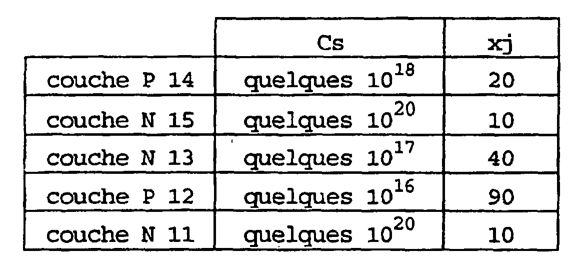

De plus pour éviter d'éventuels déclenchements parasites, on prévoit de préférence des anneaux d'arrêt de canal (stop-channel) à la périphérie interne supérieure de chacun des murs 11 et 12 (et au moins du mur 11). Ces anneaux d'arrêt de canal sont respectivement désignés par les références 21 et 22. Ils permettent d'éviter des déclenchements de transistors MOS parasites dus à la présence de tension sur des métallisations courant sur la face supérieure. Par exemple, en figure 3, le traitreliant les métallisations M3 et M4 est en fait une métallisation qui passe au dessus de l'oxyde de silicium qui est à l'aplomb de la zone comprise entre la région P1 et le mur d'isolement 11. Si cette métallisation est à un potentiel négatif par rapport à la métallisation de face arrière, on risque de faire conduire un transistor MOS à canal P (P11-N-P1) et de faire circuler du courant dans la gâchette du thyristor P2-N-P1-N1 pour l'amorcer à une tension inférieure à celle souhaitée, définie par la diode Zener N4-P7. Les anneaux d'arrêt de canal évitent cet inconvénient.

Bien entendu, la présente invention est susceptible de nombreuses variantes et adjonctions. Notamment, diverses structures usuelles, telles que ou des zones de court-circuit d'émetteur pourront être réalisées de façon classique par l'homme de l'art. Comme dans le cas de la demande de brevet susmentionnée, la structure décrite peut ne constituer qu'une partie d'un composant d'ensemble comprenant par exemple deux structures symétriques analogues à celles de la figure 3. En ce qui concerne les répartitions et les densités de courts-circuits d'émetteur dans les régions N1 et N11, on pourra se référer à l'enseignement de la demande de brevet européen susmentionnée.

## Revendications

1. Composant monolithique de protection contre des surcharges électriques susceptibles de se produire sur un conducteur (AB) en série avec lequel est disposée une résistance de détection (Rd), ce composant étant formé dans un substrat (N) d'un premier type de conductivité ayant une face supérieure et une face inférieure et comprenant :
des premières (M1-1, M1-2) et deuxièmes (M3, M4) métallisations de face supérieure destinées à être connectées aux bornes (A, B) de ladite résistance (Rd) et une troisième métallisation (M2) de face inférieure destinée à être connectée à un potentiel de référence (G) ;
un premier thyristor à gâchette de cathode (Th1) et un second thyristor à gâchette d'anode (Th2) formés tête-bêche entre les premières et troisième métallisations, les deuxièmes métallisations correspondant aux gâchettes de ces thyristors ; et
une diode à avalanche (Z1) entre les deuxième et troisième métallisations disposée pour que sa mise en avalanche provoque la mise en conduction en direct du premier thyristor ;
**caractérisé en ce que** le deuxième thyristor (Th2) est du type à déclenchement par courant de gâchette ou par retournement en direct et a sa cathode du côté de ladite face inférieure, sa tension de retournement étant sensiblement égale à la tension d'avalanche de ladite diode à avalanche et **en ce que** le premier thyristor est isolé latéralement par un mur de diffusion (11) du deuxième type de conductivité pour isoler le premier thyristor du deuxième thyristor.

2. Composant monolithique de protection selon la revendication 1, dans lequel l'ensemble du premier thyristor et de la diode à avalanche comprend :
une première couche (P2) du deuxième type de conductivité formée dans la surface inférieure du substrat ;
des deuxième (P1) et troisième (P7) régions du deuxième type de conductivité formées dans la surface supérieure du substrat ;
des quatrième (N1) et cinquième (N7) régions du premier type de conductivité respectivement formées dans les deuxième et troisième régions ;
une sixième région (N4) du premier type de conductivité formée à l'interface entre la troisième région (P7) et le substrat (N) ;
**caractérisé en ce que** le deuxième thyristor comprend :
une septième région (N11) du premier type de conductivité formée à partir de la face inférieure du substrat ;
une huitième région (P12) du deuxième type de conductivité formée à partir de la face supérieure du substrat ;
une neuvième région (N13) du premier type de conductivité formée dans la huitième région ;
une dixième région (P14) du deuxième type de conductivité formée dans la neuvième région ; et **en ce que** la première métallisation (M1-1, M1-2) est solidaire des surfaces supérieures des quatrième (N1) et dixième (P14) régions, la deuxième métallisation (M3, M4) est solidaire des troisième (P7) et neuvième (N13) régions, et une quatrième métallisation (M7) relie les deuxième (P1) et cinquième (N7) régions.

3. Composant monolithique de protection selon la revendication 1, **caractérisé en ce qu'**il comprend un anneau d'arrêt de canal (21) à la périphérie interne dudit mur de diffusion (11).

4. Composant monolithique de protection selon la revendication 2, **caractérisé en ce qu'**il comprend en outre une onzième région (N15) du premier type de conductivité de reprise de contact formée dans la neuvième région (N13).

5. Procédé de fabrication d'un composant selon la revendication 3, **caractérisé en ce que** la huitième région (P12) est formée en même temps que les murs d'isolement de face supérieure, les sixième et neuvième régions (N4, N13) sont formées simultanément, et les deuxième, troisième et dixième régions (P1, P7, P14) sont formées simultanément.

## Patentansprüche

1. Eine monolithische Komponente zum Schutz gegenüber Überströmen, die auf einer Leitung (AB) auftreten können, die in Serie zu einem Detektionswiderstand (Rd) geschaltet ist, wobei die Komponente in einem Substrat (N) eines ersten Leitfähigkeitstyps ausgebildet ist, welches eine Oberseite und eine Unterseite besitzt und folgendes aufweist:
erste (M1-1, M1-2) und zweite (M3, M4) Metallisierungen auf der Oberseite zur Verbindung der Anschlüsse (AB) des Widerstandes (Rd) und eines dritte Metallisierung (M2) auf der Unterseite zur Verbindung mit einer Bezugsspannung (G);
einen ersten Kathoden-Gate-Thyristor (Th1) und einen zweiten Anoden-Gate-Thyristor (Th2) die zur Verbindung mit den ersten und dritten Metallisierungen gleichsinnig hintereinandergeschaltet sind, wobei die zweite Metallisierung den Gates der erwähnten Thyristoren entspricht; und
eine Lawinendiode (Z1) zwischen den zweiten und dritten Metallisierungen, wobei die Diode derart geschaltet ist, dass ihre Lawine bewirkt, dass der erste Thyristor in Durchlassrichtung leitend wird;
**dadurch gekennzeichnet, dass** der zweite Thyristor (Th2) zum Gate-Trigger- oder Auslösetyp oder zum Vorwärtsdurchbruchstyp gehört und dass seine Kathode auf der Unterseite vorgesehen ist, wobei seine Durchbruchsspannung im wesentlichen gleich der Lawinenspannung der Lawinendiode ist, und wobei ferner der erste Thyristor seitlich durch eine Diffusionswand (11) des zweiten Leitfähigkeitstyps isoliert ist, um den ersten Thyristor vom zweiten Thyristor zu isolieren.

2. Die Komponente nach Anspruch 1, wobei der erste Thyristor und die Lawinendiode folgendes aufweisen:
eine erste Schicht (P2) des zweiten Leitfähigkeitstyps ausgebildet auf der Unterseite des Substrats;
zweite (P1) und dritte (P7) Regionen oder Zonen des zweiten Leitfähigkeitstyps ausgebildet auf der Oberseite des Substrats;
vierte (N1) und fünfte (N7) Zonen oder Regionen des ersten Leitfähigkeitstyps ausgebildet in den zweiten bzw. dritten Zonen bzw. Regionen;
eine sechste Zone oder Region (N4) des ersten Leitfähigkeitstyps ausgebildet auf der Zwischenfläche oder Interface zwischen der dritten Zone oder Region (P7) und dem Substrat (N); **dadurch gekennzeichnet, dass** der zweite Thyristor folgendes aufweist:
eine siebente Zone oder Region (N11) des ersten Leitfähigkeitstyps ausgebildet auf der Oberseite des Substrats;
eine achte Region oder Zone (P12) des zweiten Leitfähigkeitstyps ausgebildet auf der Unterseite des Substrats;
eine neunte Zone oder Region (N13) des ersten Leitfähigkeitstyps ausgebildet in der achten Zone oder Region;
eine zehnte Zone oder Region (P14) des zweiten Leitfähigkeitstyps ausgebildet in der neunten Zone oder Region; und
ferner **dadurch gekennzeichnet, dass** die erste Metallisierung (M1-1, M1-2) die Oberseiten der vierten (N1) und zehnten (P14) Zonen kontaktiert, die zweite Metallisierung (M3, M4) die dritte (P7) und neunte (N13) Zonen kontaktiert und eine vierte Metallisierung (M7) die zweiten (P1) und fünften (N7) Zonen verbindet.

3. Die Komponente nach Anspruch 1, wobei ferner ein Stoppkanalring (21) am Innenumfang der Diffusionswand (11) ausgebildet ist.

4. Die Komponente nach Anspruch 2, mit einer elften Kontaktzone (N15) des ersten Leitfähigkeitstyps ausgebildet in der neunten Zone (N13).

5. Ein Verfahren zur Herstellung der Komponente des Anspruchs 3, wobei die achte Zone (P12) gleichzeitig mit den Isolationswänden der Oberseite ausgebildet ist, die sechsten und neunten Zonen (N4, N13) gleichzeitig ausgebildet werden und die zweiten, dritten und zehnten Zonen (P1, P7, P14) gleichzeitig ausgebildet werden.

## Claims

1. A monolithic component to protect against over-currents liable to occur on a line (AB) that is series connected to a detection resistor (Rd), said component being formed in a substrate (N) of a first conductivity type having an upper surface and a lower surface and comprising:
first (M1-1, M1-2) and second (M3, M4) metallizations on the upper surface to connect to the terminals (A, B) of said resistor (Rd) and a third metallization (M2) on the lower surface to connect to a reference voltage (G);
a first cathode-gate thyristor (Th1) and a second anode-gate thyristor (Th2) head-to-tail connected between the first and third metallizations, the second metallization corresponding to the gates of said thyristors; and
an avalanche diode (Z1) between the second and third metallizations, said diode being connected so that its avalanching causes the first thyristor to be forward conductive;
**characterized in that** said second thyristor (Th2) is of the gate triggering type or of the forward breakover type, and has its cathode on the lower surface side, its breakover voltage being substantially equal to the avalanche voltage of said avalanche diode, and wherein the first thyristor is laterally insulated by a diffusion wall (11) of the second conductivity type, to isolate the first thyristor from the second thyristor.

2. The component of claim 1, wherein the first thyristor and the avalanche diode include:
a first layer (P2) of the second conductivity type formed in the lower surface of the substrate;
second (P1) and third (P7) regions of the second conductivity type formed in the upper surface of the substrate;
fourth (N1) and fifth (N7) regions of the first conductivity type respectively formed in the second and third regions;
a sixth region (N4) of the first conductivity type formed at the interface between the third region (P7) and the substrate (N);
**characterized in that** the second thyristor includes:
a seventh region (N11) of the first conductivity type formed from the lower surface of the substrate;
an eighth region (P12) of the second conductivity type formed from the upper surface of the substrate;
a ninth region (N13) of the first conductivity type formed in the eighth region;
a tenth region (P14) of the second conductivity type formed in the ninth region; and
**in that** the first metallization (M1-1, M1-2) contacts the upper surfaces of the fourth (N1) and tenth (P14) regions, the second metallization (M3, M4) contacts the third (P7) and ninth (N13) regions, and a fourth metallization (M7) connects the second (P1) and fifth (N7) regions.

3. The component of claim 1, further including a stop-channel ring (21) formed at the internal periphery of said diffusion wall (11).

4. The component of claim 2, further including a eleventh contacting region (N15) of the first conductivity type formed in the ninth region (N13).

5. A method for manufacturing the component of claim 3, wherein the eighth region (P12) is formed simultaneously with the insulation walls of the upper surface, the sixth and ninth regions (N4, N13) are formed simultaneously, and the second, third and tenth regions (P1, P7, P14) are formed simultaneously.
